# EUROPÄISCHE PATENTANMELDUNG

(11) **EP 1 111 694 A2**
(43) Veröffentlichungstag der Anmeldung: **27.06.2001**
(21) Anmeldenummer: 00204614.2
(22) Anmeldetag: 18.12.2000
(51) Int. Cl.: H01L 49/02, H01L 27/01

(54) **Bauteil mit Dünnschichtschaltkreis mit trimmbaren Kondensator**

(30) Priorität: 21.12.1999 DE 19961675
(71) Anmelder: Philips Corporate Intellectual Property GmbH, 52064 Aachen (DE); Koninklijke Philips Electronics N.V., 5621 BA Eindhoven (NL)
(72) Erfinder: Copetti, Carlo, Dr., c/o PHilips Corp. I.P. GmbH, 52064 Aachen (DE); Sanders, Frans, c/o Philips Corp. Int. Prop. GmbH, 52064 Aachen (DE); Fleuster, Martin, Dr., c/o Philips C. I. P. GmbH, 52064 Aachen (DE)
(74) Vertreter: Volmer, Georg, Dipl.-Ing.

(57) **Zusammenfassung**

Die Erfindung beschreibt ein Bauteil ausgerüstet mit einem Dünnschichtschaltkreis, der einen integrierten, trimmbaren Kondensator aufweist. Wenigstens eine elektrisch leitende Schicht (2, 4) des Kondensators weist eine strukturierte Fläche mit Schlitzen auf. Durch dieses fingerförmige Design besteht der eigentliche Kondensator aus mehreren, parallel geschalteten Kondensatoren. Nach Bestimmung des Gesamtkapazitätswert kann durch selektives Abtrennen von Fingern von der Hauptfläche der elektrisch leitenden Schicht (2, 4), und somit von Kondensatoren, der Gesamtkapazitätswert genau abgestimmt werden.

## Beschreibung

Die Erfindung betrifft ein Bauteil ausgerüstet mit einem Dünnschichtschaltkreis auf einem Substrat aus einem isolierenden Material, der mindestens ein passives Bauelement aufweist sowie ein Verfahren zum Feinabstimmen des Kapazitätswertes des passiven Bauelementes.

Die Entwicklung zahlreicher elektronischer Geräte ist durch folgende Trends gekennzeichnet: Miniaturisierung, höhere Zuverlässigkeit, niedrigere oder zumindest konstante Preise bei zunehmender Funktionalität. Die Anzahl der passiven Bauelemente macht erfahrungsgemäß in zahlreichen Geräten der Konsumelektronik, beispielsweise in Fernsehgeräten oder Videorecordern, 70 % der vorhandenen Bauelemente aus. Auch die rasanten Entwicklungen im Mobilfunkbereich, die stete Miniaturisierung der schnurlosen Telefonapparate und die Verwendung höherer Frequenzen führen zu erhöhten Anforderungen an die einzelnen Komponenten. Die fortschreitende Miniaturisierung führt insbesondere dazu, dass Schwankungen in den Ausgangsmaterialien und im Herstellungsprozess der passiven, elektronischen Bauelemente einen relativ großen Einfluss auf die elektrische Endspezifikation haben.

Dies trifft besonders für den Kapazitätswert zu, der sich im Fall eines Monolagenkondensators aus dem Produkt der effektiven Elektrodenfläche und der Dielektrizitätskonstanten dividiert durch die Dicke der dielektrischen Schicht berechnet.

Eine Möglichkeit, die Herstellungskosten möglichst gering zu halten, stellt die Herstellung von diskreten passiven, elektronischen Bauelementen, wie Kondensatoren, Widerstände und Induktivitäten, mit großer Spezifikationsbreite, welche durch korrigierende Nachbehandlungen (Feinabstimmen) auf die gewünschten Endspezifikation eingestellt werden, dar.

Im Zuge der steten Miniaturisierung wird aber auch die Produktion, Handhabung und Montage von diskreten passiven Bauelementen immer schwieriger. Dies kann umgangen werden, indem integrierte passive Bauelemente (IPCs) zum Einsatz kommen. Bei dieser Technik werden passive Bauelemente, wie zum Beispiel Widerstände (R), Kondensatoren (C) oder Induktoren (L) zu integrierten Grundschaltungen und Systemen kombiniert. Durch Anwendung von Dünnschichttechniken erhält man mit Hilfe von Masken auf Trägerplatten aus einem isolierenden Material sogenannte Dünnschichtschaltkreise, die einer sehr stark verkleinerten gedruckten Schaltung entsprechen. Die Herstellung von Dünnschichtschaltkreisen ist bekannt und erfolgt im allgemeinen durch verschiedene aufeinanderfolgende Beschichtungs- und Strukturierungsprozesse.

Zur Abscheidung der unterschiedlichen Schichten werden Aufdampfverfahren und Sputterverfahren verwendet. Bei diesen Verfahren können Schwankungen in der Dicke der Schichten bei den kleinen lateralen Abmessungen der passiven Bauelemente einen großen Einfluss haben. So bestimmt neben der effektiven Elektrodenfläche auch die Dicke der dielektrischen Schicht den Kapazitätswert eines Kondensators. Eine bessere Prozessbeherrschung bei der Herstellung der passiven, elektronischen Bauelemente verursacht höhere Prozesskosten.

Der Erfindung liegt die Aufgabe zugrunde, ein Bauteil mit Dünnschichtschaltkreis mit wenigstens einem Kondensator bereitzustellen, dessen Kapazitätswert abgestimmt werden kann.

Diese Aufgabe wird gelöst durch ein Bauteil ausgerüstet mit einem Dünnschichtschaltkreis auf einem Substrat aus einem isolierenden Material, der mindestens ein passives Bauelement aufweist, welches wenigstens eine erste und eine zweite elektrisch leitende Schicht und ein Dielektrikum umfasst und bei dem wenigstens eine elektrisch leitende Schicht eine strukturierte Fläche mit Schlitzen aufweist, einer Schutzschicht,
sowie mindestens einem Kontaktloch, welches das Bauteil durchdringt und
einer strukturierten Metallisierung, welche das Bauteil und das Kontaktloch bedeckt.

Durch die Schlitze in der strukturierten Fläche der ersten oder zweiten elektrisch leitenden Schicht oder in beiden elektrisch leitenden Schichten setzt sich das passive Bauelement aus mehreren, parallel geschalteten Kondensatoren zusammen. Dementsprechend setzt sich der Kapazitätswert des passiven Bauelementes aus der Summe der Kapazitätswerte der parallelen Kondensatoren zusammen. Durch Entfernen eines oder mehrerer der kleinen, parallelen Kondensatoren kann der Gesamtkapazitätswert feinabgestimmt werden.

Es ist besonders bevorzugt, dass die Schlitze eine unterschiedliche Breite aufweisen.

Es ist weiterhin bevorzugt, dass die Schlitze unterschiedliche Abstände zueinander aufweisen.

Die Genauigkeit mit der der Kapazitätswert eingestellt werden kann, hängt vom Design der elektrisch leitenden Schicht ab. Durch die Schlitze erhält die elektrisch leitende Schicht ein fingerförmiges Design. Je mehr Finger unterschiedlicher Breite eine elektrisch leitende Schicht aufweist, desto genauer kann der Kapazitätswert eingestellt werden.

Es ist weiterhin bevorzugt, dass die erste elektrisch leitende Schicht und die zweite elektrisch leitende Schicht Cu, Al, Al dotiert mit Cu, Al dotiert mit Mg, Al dotiert mit Si oder Al dotiert mit Si und Cu enthalten.

Elektrisch leitende Schichten aus diesen Materialien können mittels fokussierter Laseremission und dem dabei auftretenden Erhitzungseffekt in einen örtlich nicht leitenden Zustand überführt werden. Bei diesen verwendetem Materialien werden Teile der elektrisch leitenden Schicht durch den auftretenden Erhitzungseffekt verdampft.

Des weiteren betrifft die Erfindung ein Verfahren zum Feinabstimmen des Kapazitätswertes eines passiven Bauelement, welches wenigstens eine erste und eine zweite elektrisch leitende Schicht sowie ein Dielektrikum umfasst und bei dem wenigstens eine elektrisch leitende Schicht eine strukturierte Fläche mit Schlitzen aufweist,
in einem Bauteil ausgerüstet mit einem Dünnschichtschaltkreis auf einem Substrat aus einem isolierenden Material, mit einer Schutzschicht,
sowie mindestens einem Kontaktloch, welches das Bauteil durchdringt und einer strukturierten Metallisierung, welche das Bauteil und das Kontaktloch bedeckt, bei dem mittels fokussierter Laseremission örtlich auf wenigstens eine elektrisch leitende Schicht ein Erhitzungseffekt erreicht wird und Teile der elektrisch leitenden Schicht verdampft werden.

Nach Herstellung des Bauteils ausgerüstet mit einem Dünnschichtschaltkreis, der mindestens einen Kondensator aufweist, wird der Kapazitätswert des Kondensators bestimmt. Der Kapazitätswert ist die Summe der Kapazitätswerte der kleinen, parallelen Kondensatoren, die sich durch die Schlitze in der strukturierten Fläche wenigstens einer elektrisch leitenden Schicht ergeben. Anschließend wird mittels fokussierter Laseremission die entsprechende Anzahl an parallelen Kondensator abgetrennt, um den gewünschten Kapazitätswert zu erhalten.

Im folgenden soll die Erfindung anhand von zwei Figuren und einem Ausführungsbeispiel erläutert werden.

### Dabei zeigt

- Fig. 1: im Querschnitt den schematischen Aufbau eines Bauteils ausgerüstet mit Dünnschichtschaltkreises, der einen Kondensator umfasst, und
- Fig. 2: eine elektrisch leitende Schicht mit Schlitzen.

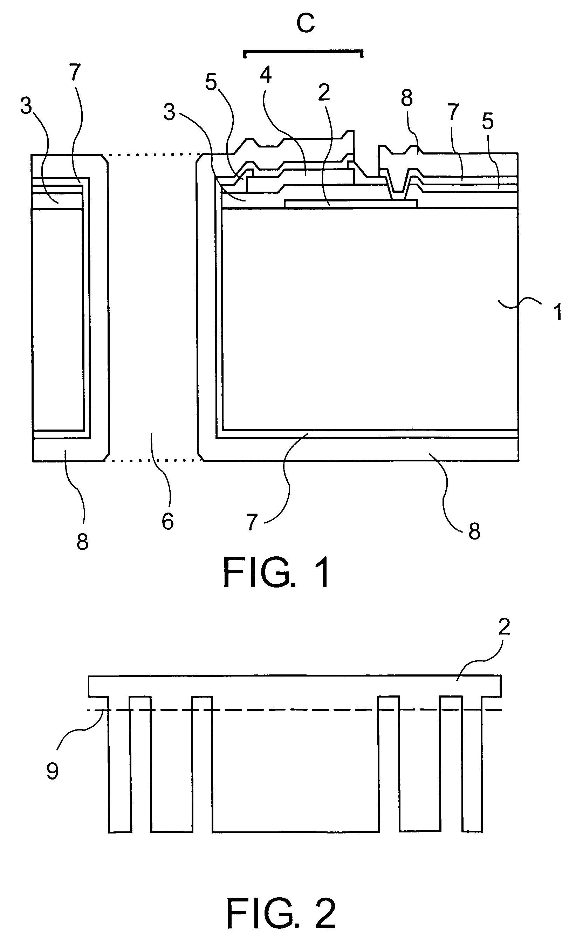

Gemäß Fig. 1 weist ein Bauteil ausgerüstet mit einem Dünnschichtschaltkreis ein Substrat 1 auf, welches beispielsweise ein keramisches Material, ein glaskeramisches Material, ein Glasmaterial oder ein keramisches Material mit einer Planarisierungsschicht aus Glas oder einem organischen Material enthält. Bevorzugt enthält das Substrat 1 Al₂O₃, Glas oder Al₂O₃ mit einer Planarisierungsschicht aus Glas, Polyimid oder Polybenzocyclobuten. Auf dieses Substrat 1 ist eine erste elektrisch leitende Schicht 2 aufgebracht, welche eine strukturierte Fläche mit Schlitzen aufweist. Auf dieser strukturierten ersten elektrisch leitenden Schicht 2 befindet sich ein Dielektrikum 3, welches im allgemeinen die ganze Fläche des Substrats 1 bedeckt und nur an bestimmten Stellen unterbrochen ist, um Vias zu der darunterliegenden ersten elektrisch leitenden Schicht 2 herzustellen. Das Dielektrikum 3 kann beispielsweise Si₃N₄, SiO₂, SiₓO_{y}N_{z} (0 ≤ x ≤ 1, 0 ≤ y ≤ 1, 0 ≤ z ≤ 1) oder Ta₂O₅ enthalten. Auf das Dielektrikum 3 ist eine zweite elektrisch leitende Schicht 4 abgeschieden und strukturiert. Die erste elektrisch leitende Schicht 2 sowie die zweite elektrisch leitende Schicht 4 können zum Beispiel Cu, Al, Al dotiert mit einigen Prozent Cu, Al dotiert mit einigen Prozent Mg, Al dotiert mit einigen Prozent Si oder Al dotiert mit einigen Prozent Si und Cu enthalten. Über dem gesamten Bereich des Substrats 1 ist eine Schutzschicht 5 aus einem anorganischen Material wie beispielsweise SiO₂, Si₃N₄ oder SiₓO_{y}N_{z} (0 ≤ x ≤ 1, 0 ≤ y ≤ 1, 0 ≤ z ≤ 1) aufgebracht. Alternativ kann auch ein organisches Material wie zum Beispiel Polyimid oder Polybenzocyclobuten verwendet werden. Außerdem weist das gesamte Bauteil mindestens ein Kontaktloch 6 auf. Das Bauteil sowie das Kontaktloch 6 sind mit einer strukturierten Metallisierung bedeckt, welche wiederum wenigstens eine Basisschicht 7 enthält. Es kann bevorzugt sein, dass auf die Basisschicht 7 eine Deckschicht 8 aufgebracht ist. In diesem Fall fungiert die Basisschicht 7, welche beispielsweise Cr/Cu enthält, als Keimschicht für die galvanische Abscheidung der Deckschicht 8. Die Deckschicht 8 enthält zum Beispiel Cu/Ni/Au.

Alternativ können die erste und zweite elektrisch leitende Schicht 2, 4 oder auch nur die zweite elektrisch leitende Schicht 4 nach dem Aufbringen derart strukturiert werden, dass sie Schlitze aufweisen.

Weiterhin kann auf das Substrat 1 eine Barriereschicht aufgebracht sein, welche beispielsweise Si₃N₄ enthält. Auf das Substrat 1 oder die Barriereschicht kann außerdem noch eine Widerstandsschicht abgeschieden und strukturiert sein. Diese strukturierte Widerstandsschicht kann beispielsweise NiₓCr_{y}Al_{z} (0 ≤ x ≤1, 0 ≤ y ≤ 1, 0 ≤ z ≤ 1), SiₓCr_{y}O_{z} (0 ≤ x ≤1, 0 ≤ y ≤ 1, 0 ≤ z ≤ 1), SiₓCr_{y}N_{z} (0 ≤ x ≤1, 0 ≤ y ≤ 1, 0 ≤ z ≤ 1), CuₓNi_{y} (0 ≤ x ≤1, 0 ≤ y ≤ 1) oder TiₓW_{y} (0 ≤ x ≤1, 0 ≤ y ≤ 1) enthalten.

Außerdem können an gegenüberliegenden Seiten des Bauteiles Stromzuführungen befestigt sein. Als Stromzuführung kann ein galvanischer SMD-Endkontakt aus Cr/Cu, Ni/Sn oder Cr/Cu, Cu/Ni/Sn oder Cr/Ni, Pb/Sn, ein Bump-end-Kontakt, eine Castellation aus Cr/Cu, Cu/Ni/Au, ein Ballgridarray aus einer Cr/Cu/Ni-Schicht mit einer Kugel aus Sn oder PbSn-Legierung oder ein Landgridarray aus Cr/Cu eingesetzt werden.

In Fig. 2 ist eine elektrisch leitende Schicht 2 mit Schlitzen gezeigt. Die Breite der Schlitze und der Abstand der Schlitze zueinander ist beliebig. Durch die Schlitze erhält die elektrisch leitende Schicht 2 ein fingerförmiges Design. Je mehr Finger verschiedenster Breite die elektrisch leitende Schicht 2 aufweist, desto genauer kann der Kapazitätswert abgestimmt werden. Außerdem ist die Schnittlinie 9 des Lasers gezeigt. An dieser Stelle wird mittels fokussierter Laseremission ein oder mehrere Finger vom Hauptteil der elektrisch leitenden Schicht 2 abgetrennt. In diesem Bereich weist der Dünnschichtschaltkreis keine Metallisierung auf.

Im folgenden wird eine Ausführungsform der Erfindung erläutert, die eine beispielhafte Realisierungsmöglichkeiten darstellt.

### Ausführungsbeispiel 1

Auf ein Substrat 1 aus Al₂O₃ mit einer Planarisierungsschicht aus Glas wurde eine erste elektrische leitende Schicht 2 aus Al dotiert mit 4 % Cu abgeschieden und durch Schlitze so strukturiert, dass sie ein fingerförmiges Aussehen erhielt. Die erste elektrisch leitende Schicht 2 wies dadurch fünf Finger unterschiedlicher Breite auf. Im nächsten Schritt wurde über die gesamte Fläche des Substrates 1 ein Dielektrikum 3 aus Si₃N₄ abgeschieden. Auf dem Dielektrikum 3 wurde eine zweite elektrisch leitende Schicht 4 aus Al dotiert mit 4 % Cu abgeschieden und strukturiert. Der gesamte Dünnschichtschaltkreis wurde mit einer Schutzschicht 5 aus Si₃N₄ versehen. Anschließend wurden zur elektrischen Kontaktierung der ersten elektrisch leitenden Schicht 2 Vias durch die Schutzschicht 5 und das Dielektrikum 3 geätzt. Weiterhin wurden mehrere Kontaktlöcher 6, welche das Bauteil komplett durchdringen, mittels eines Lasers geschaffen. Um das Bauteil sowie in die Kontaktlöcher 6 wurde eine strukturierte Metallisierung aus einer Basisschicht 7 aus Cr/Cu und einer Deckschicht 8 aus Cu/Ni/Au aufgebracht. Außerdem sind an beiden Seiten des Bauteiles Ballgridarrays mit einer Schicht aus Cr/Cu/Ni und aufgesetzten Kugeln aus Sn als Stromzuführungen befestigt.

Anschließend wurde der Gesamtkapazitätswert des Kondensators, der sich aus fünf kleineren, parallelen Kondensatoren zusammensetzte, bestimmt. Von den fünf Kondensatoren bzw. Fingern trug ein Finger 70 %, zwei Finger jeweils 10 % und zwei Finger jeweils 5 % zum Gesamtkapazitätswert bei. Dementsprechend konnte der Wert der Gesamtkapazität maximal um 30 % feinabgestimmt werden. Die Toleranz betrug dabei maximal ± 2.5 %. Die Feinabstimmung des Kapazitätswertes des Kondensators wurde durch Abtrennen der entsprechenden Anzahl an Fingern der elektrisch leitenden Schicht 2 erreicht. Dabei wurden Teile der elektrisch leitenden Schicht 2 entlang der Laserschnittlinie 9 durch fokussierte Emission eines Argon-Lasers verdampft.

## Patentansprüche

1. Bauteil ausgerüstet mit einem Dünnschichtschaltkreis auf einem Substrat (1) aus einem isolierenden Material, der mindestens ein passives Bauelement aufweist, welches wenigstens eine erste (2) und eine zweite (4) elektrisch leitende Schicht und ein Dielektrikum (3) umfasst und bei dem wenigstens eine elektrisch leitende Schicht (2, 4) eine strukturierte Fläche mit Schlitzen aufweist,
einer Schutzschicht (5),
sowie mindestens einem Kontaktloch (6), welches das Bauteil durchdringt und einer strukturierten Metallisierung, welche das Bauteil und das Kontaktloch (6) bedeckt.

2. Bauteil ausgerüstet mit einem Dünnschichtschaltkreis nach Anspruch 1,
dadurch gekennzeichnet,
dass die Schlitze eine unterschiedliche Breite aufweisen.

3. Bauteil ausgerüstet mit einem Dünnschichtschaltkreis nach Anspruch 1,
dadurch gekennzeichnet,
dass die Schlitze unterschiedliche Abstände aufweisen.

4. Bauteil ausgerüstet mit Dünnschichtschaltkreis nach Anspruch 1,
dadurch gekennzeichnet,
dass die erste elektrisch leitende Schicht (2) und die zweite elektrisch leitende Schicht (4) Cu, Al, Al dotiert mit Cu, A1 dotiert mit Mg, Al dotiert mit Si oder Al dotiert mit Si und Cu enthalten.

5. Verfahren zum Feinabstimmen des Kapazitätswertes eines passiven Bauelement, welches wenigstens eine erste (2) und eine zweite (4) elektrisch leitende Schicht sowie ein Dielektrikum (3) umfasst und bei dem wenigstens eine elektrisch leitende Schicht (2, 4) eine strukturierte Fläche mit Schlitzen aufweist,
in einem Bauteil ausgerüstet mit einem Dünnschichtschaltkreis auf einem Substrat (1) aus einem isolierenden Material, mit einer Schutzschicht (5),
sowie mindestens einem Kontaktloch (6), welches das Bauteil durchdringt und einer strukturierten Metallisierung, welche das Bauteil und das Kontaktloch (6) bedeckt, bei dem mittels fokussierter Laseremission örtlich auf wenigstens eine elektrisch leitende Schicht (2, 4) ein Erhitzungseffekt erreicht wird und Teile der elektrisch leitenden Schicht (2, 4) verdampft werden.
